Europäisches Patentamt

European Patent Office

Office européen des brevets

(19)

(11) Publication number: **0 220 914**
**B1**

## EUROPEAN PATENT SPECIFICATION

(12)

(45) Date of publication of the patent specification:
03.10.90

(51) Int. Cl.⁵: **H03B 5/12**

(21) Application number: **86308139.4**

(22) Date of filing: **20.10.86**

(54) Balanced oscillator and heterodyne circuit incorporating same.

(30) Priority: **22.10.85 GB 8525984**

(43) Date of publication of application:
**06.05.87 Bulletin 87/19**

(45) Publication of the grant of the patent:
**03.10.90 Bulletin 90/40**

(84) Designated Contracting States:
**DE FR NL**

(56) References cited:
**EP-A- 0 017 899**
**CH-A- 393 446**
**DE-B- 1 261 900**
**DE-B- 1 815 675**
**DE-B- 1 930 483**
**DE-B- 2 005 888**
**DE-C- 3 219 817**
**US-A- 3 881 159**

(73) Proprietor: **PLESSEY OVERSEAS LIMITED, Vicarage Lane, Ilford Essex IG1 4AQ(GB)**

(72) Inventor: **Cowley, Nicholas Paul, 10 Summerhouse Road, Wroughton Wiltshire(GB)**
Inventor: **Lawton, Rodney James, 18 Washpool, Swindon Wiltshire(GB)**
Inventor: **McClelland, Thomas David Stephen, 7 Neares Drive, North Shaw Swindon SN5 9QN(GB)**

(74) Representative: **Fish, Norman Ernest et al, The Plessey Company plc Intellectual Property Department Vicarage Lane, Ilford Essex IG1 4AQ(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

Technical Field

The present invention concerns improvements in or relating to the design of oscillators, especially but not exclusively, oscillators suitable for use in heterodyne applications.

Implimentations of the invention, as discussed below, may be adapted, for example, for use in the tuning circuits of satellite communication receivers.

Background Art

It is known to employ oscillators in a dual purpose role in the construction of tuning circuits - ie. both as a local oscillator source and as a mixer.

It is however a problem that radiation at oscillator frequency can couple to adjacent circuitry. Attention must therefore be paid to circuit layout and it is usual to partition the system circuits by metal screens, adding therefore to weight bulk and cost. Furthermore it is also a problem that signals at oscillator frequency can leak back to connected input circuitry.

The invention, as disclosed herein, is intended as a remedy to the problems aforesaid - ie. it is intended to provide an oscillator wherein radiation at oscillator frequency is minimal and conductive feedback to oscillator input circuitry is significantly reduced.

DE-B-1 815 675 discloses an oscillator of balanced configuration including a pair of matched transistors, a current source connected to the input ports of the transistors and a differential load connected between the output port of each transistor for extraction of signal at resonant frequency.

In accordance with the present invention there is provided an oscillator of balanced configuration comprising:

a pair of matched transistors,

current being fed to the input ports of the transistors, and a differential load connected between the output port of each transistor for extraction of signal at resonant frequency characterised in that said oscillator includes a pair of matched current sources, one connected to the input port of each transistor;

first impedance means connected between the control port of each transistor; and,

second impedance means connected between the input port of each transistor;

one of said impedance means being a resonant impedance network;

the other impedance means being a reactance;

the choice of transistors, resonant network, and reactance, being such that the reactance shall appear as a shunt of negative resistance across the resonant network, and such as to sustain oscillation at network resonant frequency.

At resonance, and in the case of perfect matching, the signals output from the transistors have components at the fundamental resonant frequency that are equal in magnitude but in antiphase. These components therefore add constructively when applied to the differential load.

The characteristic of each transistor is non-linear and harmonics are also generated. Signal components at the second harmonic and at other even harmonics are in-phase and balanced. These therefore cancel where applied to the differential load.

In practical circumstances, matching is unlikely to be perfect. However, at the output node, signal at the resonant frequency will be significantly enhanced, and the signal at second harmonic frequency substantially attenuated as a result.

Since at the oscillator frequency, current swings in the two arms of the oscillator are balanced and in opposition, electromagnetic radiative coupling to adjacent circuitry is substantially reduced and conductive feedback to input circuitry practically eliminated.

Other advantages of the invention, and advantages of particular embodiments thereof, will become apparent from the description that is give below.

It is noted that the transistors employed are most conveniently of bipolar type, since the high speed of operation, characteristic of these devices, can be exploited. Notwithstanding, other types of transistor, for example MOS field effect transistor and junction field effect transistor types and the like, may be employed.

The resonant network, referred to above, may be parallel, series or combination tuned. It may also include one or more components of continuous or step-wise variable impedance, thus making it possible either to tune the oscillator over a range of frequencies, or to select each one of a set of discrete attainable frequencies. It may be floated or it may be tied to a reference potential. In the latter case, it is important that it be of a balanced design, so that oscillator balance is not unduly disturbed, for otherwise the requisite signal balance would be diminished and radiation, as also feedback conduction, would be increased.

It is noted that the current sources need not be ideal. In the simplest implimentation, matched resistors may be used as sources.

The current source may be such as to provide only DC current. In this case, the output signal will be comprised of signals at the fundamental resonant frequency and other odd harmonics only.

Alternatively, the current sources may be such as to provide AC modulated current. It is of especial significance that in this case the output signal will be comprised not only of signals at the fundamental resonant frequency and other odd harmonics, but also of side-band signals derived from the AC modulated current signals. With this modification, therefore, it can be seen that the oscillator can be used in a dual purpose role, ie. both as a source of oscillation and as a mixer. The oscillator, defined, can thus be employed as the local oscillator or as the oscillator-mixer of a heterodyne tuning circuit.

Referring to the impedance means, it is preferable that the resonant network is connected between the control ports of the transistors. The reactance is, in this case, a capacitor or capacitative network. Capacitors of suitable value can be implimented by on-chip construction.

In the less favoured alternative, the resonant network is connected between the input ports of the transistors. In this latter case the reactance is an inductance or inductive network. It is not however practical to impliment inductors of suitable value by means of on-chip construction. Where the oscillator is constructed on-chip, pins must be provided for connection to an external inductor, making this alternative altogether less attractive.

Brief Introduction of the Drawings

In the drawings accompanying this specification:-

Figure 1 is a block schematic circuit diagram of an oscillator configured in accordance with this invention;

Figures 2 and 3 are circuit diagrams of two alternative implimentations of the oscillator shown in the preceding figure;

Figure 4 is an equivalent circuit diagram for a resonant circuit and load;

Figure 5 is a circuit diagram showing practical detail for the implimentation of figure 2 above; and,

Figure 6 and 7 are, respectively, a block schematic and a circuit diagram of a mixer-oscillator configured in accordance with this invention.

Description of Preferred Embodiments

Embodiments of the invention will now be described, by way of example only, with reference to the accompanying drawings.

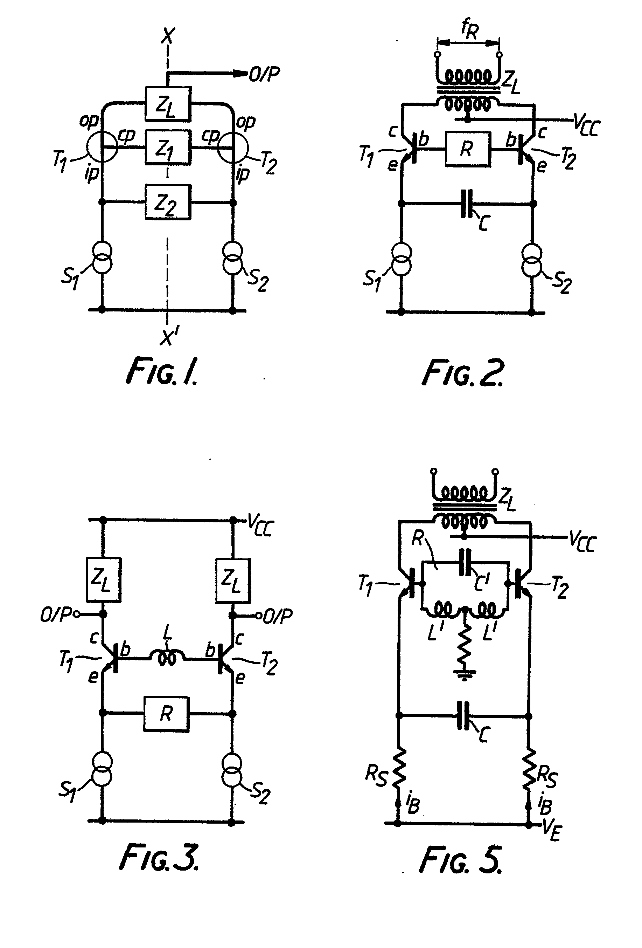

An oscillator of balanced design is shown in figure 1. This comprises a pair of matched transistors $T_1$, $T_2$ the input ports ip of which are connected to current sources, $S_1$, $S_2$. A first impedance $Z_1$ is connected between the control ports cp of the two transistors $T_1$, $T_2$. A second impedance $Z_2$ is connected between the input ports ip of the two transistors $T_1$, $T_2$. The output ports op of these transistors $T_1$, $T_2$ are connected each side of a differential load $Z_L$ from which output O/P signal is extracted.

A bipolar transistor implimentation of this circuit is shown in figure 2. Here a resonant impedance network R is connected across the bases b of the two transistors $T_1$, $T_2$ and a capacitor C is connected across the two emitter inputs e of the transistors $T_1$, $T_2$.

The collector outputs c are connected to a centre tapped transformer, differential load $Z_L$.

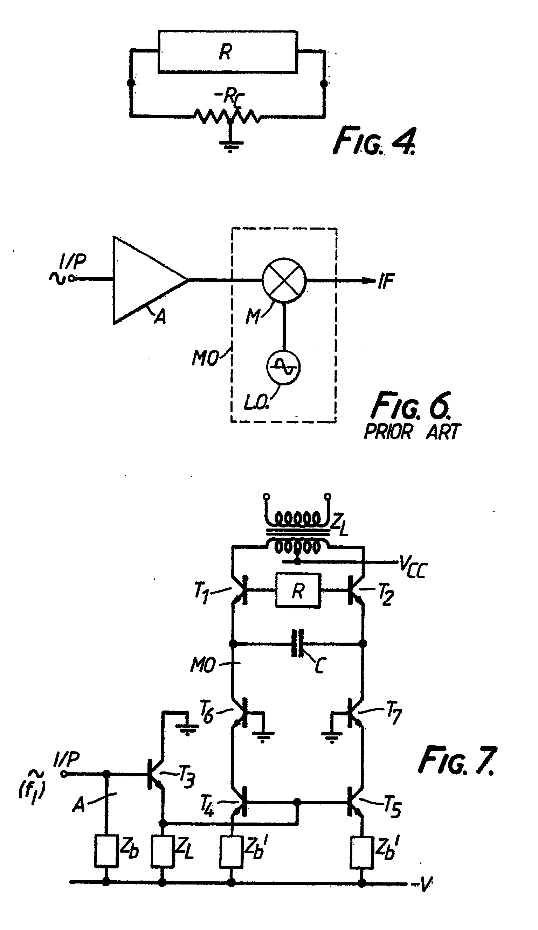

In operation, the capacitance C appears as a negative resistive shunt - $R_c$ "across" the resonant network R (see Figure 4). This impedance transformation results from transistor action, where a quadrature phase lag is introduced across the emitter and base of each transistor:-

$$= - \frac{w_T}{jw} . \frac{1}{jwC} = w_T/w^2C .$$

.... Equation 1.

In the equation appearing above, B is the impedance transform factor of each transistor, w is the angular frequency, and $w_T$ the angular transformation frequency ($2 \pi f_T$) of each transistor [$f_T$ is defined here as the frequency at which transistor current gain is unity].

For oscillation to build up, it is requisite that the resonant impedance (a purely resistive term R) of the resonant circuit should not exceed the value of the negative resistance:-

$$w_T/w_R^2C > R$$ .... Inequality 1.

Where this inequality is satisfied, power, effectively generated by the negative resistance $R_c$, outweighs power dissipated in the resonant network R and signal, at resonant frequency $f_R$, builds up.

The large signal gain of the transistors $T_1$, $T_2$ falls off as signal level increases, and, a point is reached where power generation is matched by power dissipation and a steady-state level of oscillation is produced.

Signals applied to the base b of the transistors $T_1$, $T_2$ are maintained in antiphase by the resonant circuit R. Resonant frequency signals at the collector outputs c of the transistors are thus of opposite phase. Since the oscillator is of balanced design, the signals are of equal magnitude. These signals thus add constructively when applied to the differential load. However, signals at the second harmonic, as also signals at higher even harmonics, are maintained in-phase and cancel.

Further detail of this oscillator circuit is shown in figure 5. The ouput signal is extracted from the secondary coil of the transformer $Z_L$. The resonant circuit R comprises a capacitor C' and a centre-tapped inductor, each branch of which is of inductance L'. Current sources are provided by two matched resistors $R_S$ and a DC bias current $i_B$ is shown flowing through each of these. Typical practical values are tabulated below:-

## TABLE 1

| | |
|---|---|
| Resonant frequency, | $f_R$ : $1GH_Z$ |
| Transistor transformation frequency, | $f_T$ : $6GH_Z$ |
| Resonant capacitance, | C' : 0.8pF |
| Resonant inductance, | L' : 8nH |
| Coupling capacitance, | C : 1pF |
| Source current (DC), | $i_B$ : 6mA |
| Collector line voltage, | $V_{cc}$: 5V |
| Source reference voltage, | $V_E$ : −2V. |

It is noted that a circuit with equivalent performance can be implimented using an inductance L across the transistor bases b, in place of the resonant circuit R, and by replacing this resonant circuit R across the emitters e as shown in figure 3. In this configuration, the inductance likewise appears as a shunt of negative impedance across the resonant network R. Resitive impedances $Z_L$, which together provide a differential load, are shown in each collector line and balanced outputs O/P taken from each.

A known synthesis loop arrangement is shown in part in figure 6. Here, an input signal is fed to the input I/P of a gain stage A where it either undergoes amplification or voltage/current conversion. It is then fed to a common mixer-oscillator circuit MO and mixed (M) with local oscillator (LO) signal to produce a sideband signal at intermediate frequency (IF). The oscillator discussed above may be utilised as mixer-oscillator in this application. A practical circuit is shown in figure 7.

The trans-conductance stage A shown is an emitter follower comprising a transistor $T_3$, and bias and load impedances $Z_b$, $Z_L$ arranged in conventional manner. The signal output from this trans-conductance stage is thereafter applied to modulate the source current. Each current source $S_1$, $S_2$ of the oscillator MO comprises a pair of transistors ($T_4$, $T_6$, and $T_5$ and $T_7$) and a bias impedance $Z'_b$. The bases of transistors $T_6$ and $T_7$ are connected to device earth. The signal is applied to the bases of the two other transistors $T_4$ and $T_5$ and thus modulates the source current at input frequency $f_i$. A signal of frequency ($f_R$-$f_i$) is thus developed.

## Claims

1. An oscillator of balanced configuration comprising:
a pair of matched transistors ($T_1$, $T_2$),
current being fed to the input ports (ip, e) of the transistors ($T_1$, $T_2$), and a differential load ($Z_L$) connected between the output port of each transistor ($T_1$, $T_2$) for extraction of signal at resonant frequency ($f_R$) characterised in that said oscillator includes a pair of matched current sources ($S_1$, $S_2$; $R_S$; $T_6$, $T_7$), one connected to the input port (ip; e) of each transistor ($T_1$, $T_2$);
first impedance means ($Z_1$) connected between the control port (cp; b) of each transistor ($T_1$, $T_2$); and,
second impedance means ($Z_2$) connected between the input port (ip; e) of each transistor ($T_1$, $T_2$);
one of said impedance means ($Z_1$; $Z_2$) being a resonant impedance network (R);
the other impedance means ($Z_2$; $Z_1$) being a reactance (C; L); the choice of transistors ($T_1$, $T_2$), resonant network (R), and reactance (C; L) being such that the reactance (C; L) shall appear as a shunt of negative resistance ($-R_c$) across the resonant network (R), and such as to sustain oscillation at network resonant frequency ($f_R$).

4

2. An oscillator as claimed in claim 1, wherein the first impedance means ($Z_1$) is a resonant impedance network (R), and the second impedance means ($Z_2$) is a capacitance (c).

3. An oscillator as claimed in claim 1, wherein the first impedance means ($Z_1$) is an inductance (L) and the second impedance means ($Z_2$) is a resonant impedance network (R).

4. An oscillator as claimed in any one of the preceding claims, wherein the frequency of resonance ($f_R$) is continuously or step-wise variable.

5. An oscillator as claimed in any one of the preceding claims, wherein the transistors ($T_1$, $T_2$) aforesaid are each bipolar.

6. An oscillator as claimed in any one of the preceding claims, wherein said current sources ($S_1$, $S_2$) comprise each a matched resistor ($R_S$).

7. An oscillator as claimed in any one of the preceding claims 1 to 5, wherein each source ($S_1$, $S_2$; $T_4$ to $T_7$) aforesaid is responsive to input signal ($f_I$) for modulating source current ($i_B$).

8. Use of an oscillator as claimed in claim 7, as a mixer-oscillator in a tuning circuit.

**Patentansprüche**

1. Schwinger in Gegentakt-Anordnung, bestehend aus zwei angepaßten Transistoren ($T_1$, $T_2$),

den Eingangskanälen (ip, e) der Transistoren ($T_1$, $T_2$) zugeleitetem Strom und einer zwischen die Ausgangskanäle der Transistoren ($T_1$, $T_2$) geschalteten Differentiallast ($Z_L$) zur Extraktion eines Signals mit Eigenfrequenz ($f_R$),

dadurch gekennzeichnet, daß besagter Schwinger zwei angepaßte Stromquellen ($S_1$, $S_2$; $R_S$; $T_6$, $T_7$), die jeweils an die Eingangskanäle (ip; e) der Transistoren ($T_1$, $T_2$) angeschlossen sind,

einen ersten Widerstand ($Z_1$), der zwischen die Steuerkanäle (cp; b) der Transistoren ($T_1$, $T_2$) geschaltet ist, und

einen zweiten Widerstand ($Z_2$), der zwischen die Eingangskanäle (ip; e) der Transistoren ($T_1$, $T_2$) geschaltet ist, enthält,

wobei einer der besagten Widerstände ($Z_1$; $Z_2$) ein Resonanzwiderstandsnetz (R)

und der andere Widerstand ($Z_2$; $Z_1$) ein Blindwiderstand (C; L) ist, und wobei die Transistoren ($T_1$, $T_2$), das Resonanznetz (R) und der Blindwiderstand (C; L) so gewählt werden, daß der Blindwiderstand (C; L) als Nebenschluß mit Negativwiderstand ($-R_C$) über dem Resonanznetz (R) erscheint und Schwingung mit Netzeigenfrequenz ($f_R$) aufrecht erhalten wird.

2. Schwinger nach Anspruch 1, dadurch gekennzeichnet, daß der erste Widerstand ($Z_1$) ein Resonanzwiderstandsnetz (R) und der zweite Widerstand ($Z_2$) ein kapazitiver Blindwiderstand (C) ist.

3. Schwinger nach Anspruch 1, dadurch gekennzeichnet, daß der erste Widerstand ($Z_1$) ein induktiver Widerstand (L) und der zweite Widerstand ($Z_2$) ein Resonanzwiderstandsnetz (R) ist.

4. Schwinger nach einem der vorhergehenden Ansprüche, dadurch gekennzeichnet, daß die Eigenfrequenz ($f_R$) stufenlos oder stufenweise variabel ist.

5. Schwinger nach einem der vorhergehenden Ansprüche, dadurch gekennzeichnet, daß die genannten Transistoren ($T_1$, $T_2$) bipolar sind.

6. Schwinger nach einem der vorhergehenden Ansprüche, dadurch gekennzeichnet, daß besagte Stromquellen ($S_1$, $S_2$) jeweils aus einem angepaßten Widerstand ($R_S$) bestehen.

7. Schwinger nach einem der Ansprüche 1 bis 5, dadurch gekennzeichnet, daß die genannten Stromquellen ($S_1$; $S_2$; $T_4$ bis $T_7$) jeweils auf Eingangssignale ($f_I$) für die Modulierung des Quellenstroms ($i_B$) ansprechen.

8. Anwendung eines Schwingers nach Anspruch 7 als Mischer-Schwinger in einem Abstimmkreis.

**Revendications**

1. Oscillateur de configuration équilibrée, comprenant:

une paire de transistors appariés ($T_1$, $T_2$),

un courant étant transmis aux entrées (ip, e) des transistors ($T_1$, $T_2$), et une charge différentielle ($Z_L$) étant connectée entre les sorties des transistors ($T_1$, $T_2$) afin qu'un signal soit extrait à la fréquence de résonance ($f_R$),

caractérisé en ce que l'oscillateur comporte une paire de sourcs appariées de courant ($S_1$, $S_2$; $R_S$; $T_6$, $T_7$) connectées chacune à une entrée (ip; e) d'un transistor ($T_1$, $T_2$),

un premier dispositif à impédance ($Z_1$) connecté entre les entrées de commande (cp; b) des transistors ($T_1$, $T_2$), et

un second dispositif à impédance ($Z_2$) connecté entre les entrées (ip; e) des transistors ($T_1$, $T_2$),

l'un des dispositifs à impédance ($Z_1$; $Z_2$) étant un réseau résonant d'impédances (R),

l'autre dispositif à impédance ($Z_2$; $Z_1$) étant une réactance (C; L),

le choix des transistors ($T_1$, $T_2$) du réseau résonant (R) et de la réactance (C; L) étant tel que la réactance (C; L) apparaît comme un shunt de résistance négative ($-R_C$) aux bornes du réseau résonant (R), et qu'une oscillation est entretenue à la fréquence de résonance du réseau ($f_R$).

2. Oscillateur selon la revendication 1, dans lequel le premier dispositif à impédance ($Z_1$) est un réseau résonant d'impédances (R), et le second dispositif à impédance ($Z_2$) est une capacité (C).

3. Oscillateur selon la revendication 1, dans lequel le premier dispositif à impédance ($Z_1$) est une inductance (L) et le second dispositif à impédance ($Z_2$) est un réseau résonant d'impédances (R).

4. Oscillateur selon l'une quelconque des revendications précédentes, dans lequel la fréquence de résonance ($f_R$) peut varier de façon continue ou par paliers.

5. Oscillateur selon l'une quelconque des revendications précédentes, dans lequel les transistors ($T_1$, $T_2$) sont tous de type bipolaire.

6. Oscillateur selon l'une quelconque des revendications précéndentes, dans lequel les sources de courant ($S_1$, $S_2$) comportent chacune une résistance appariée ($R_S$).

7. Oscillateur selon l'une quelconque des revendications précédentes 1 à 5, dans lequel chaque source de courant ($S_1$, $S_2$; $T_4$ à $T_7$) est sensible à un signal d'entrée ($f_I$) de modulation du courant de source ($i_B$).

8. Application d'un oscillateur selon la revendication 7 comme mélangeur-oscillateur dans un circuit d'accord.

FIG. 1.

FIG. 2.

FIG. 3.

FIG. 5.

FIG. 4.

FIG. 6.
PRIOR ART

FIG. 7.